# EUROPEAN PATENT APPLICATION

(11) **EP 0 587 943 A1**
(43) Date of publication of application: **23.03.1994**
(21) Application number: 92121190.0
(22) Date of filing: 11.12.1992
(51) Int. Cl.: H03F 3/50, H03K 19/017

(54) **Voltage follower circuit**

(30) Priority: 18.09.1992 JP 275217/92
(71) Applicant: YOZAN INC., Tokyo 155 (JP); SHARP KABUSHIKI KAISHA, Osaka 545 (JP)
(72) Inventor: Shu, Guoliang, Setagaya-ku, Tokyo 155 (JP); Yang, Weikang, Setagaya-ku, Tokyo 155 (JP); Wongwarawipat, Wiwat, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

A voltage follower circuit comprising nMOS whose drain is connected to power source and pMOS whose drain is connected to said source of nMOS and whose source is grounded, wherein input voltage is connected to gates of nMOS and pMOS, a source of nMOS is connected to an output terminal, and said output terminal is grounded through capacitance.

## Description

### -FIELD OF THE INVENTION-

The present invention relates to a voltage follower circuit.

### -BACKGROUND OF THE INVENTION-

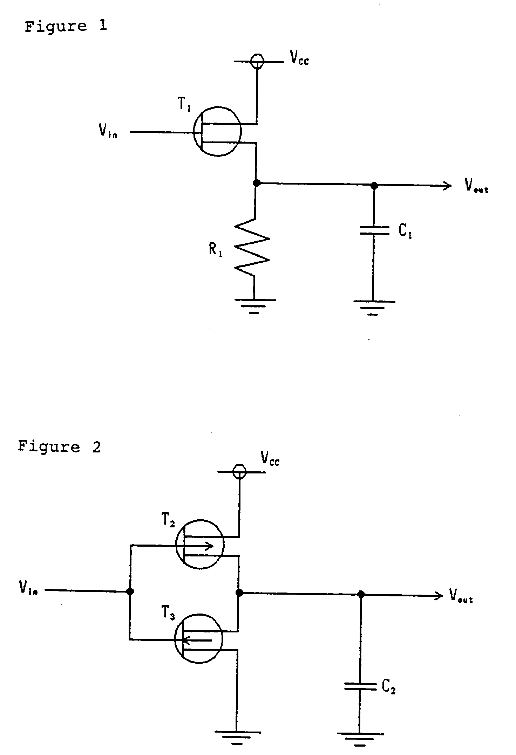

A voltage follower circuit is conventionally known as a buffer amplifier. The conventional circuit shown in Figure 1 keeps the level of output voltage by grounding the source of MOSFET through resistor R1. When the value of R1 is small, the level of output voltage is lower and when it is large, the output voltage Vout is badly responsive because of increase of the constant on a discharge of electricity from parasitic capacitance C1.

### -SUMMARY OF THE INVENTION-

The present invention is invented so as to solve the above conventional problems and has an object to provide a responsive voltage follower circuit without leaking the necessary output level of voltage.

The voltage follower circuit according to the present invention uses cMOS, connects power source to the drain of nMOS, also connects the source of pMOS to the lower voltage, connects the source of nMOS and the drain of pMOS, inputs input voltage to nMOS and pMOS, and connects the drain of pMOS to the output terminal. Therefore, the output voltage can be preserved by the resistance between source drains of pMOS on non-conductive condition, and high responsive performance is realized by discharging parasitic capacitance caused by conduction of pMOS.

### BRIEF DESCRIPTION OF THE DRAWINGS

Figure 1 shows a circuit of a conventional voltage follower circuit.

Figure 2 shows a circuit of the first embodiment.

Figure 3 shows a graph comparing the input and output characteristic of the voltage of the embodiment in Figure 2 with conventional one.

Figure 4 shows a circuit of the second embodiment.

Figure 5 shows a graph of the characteristic of the input and output of the voltage of the embodiment shown in Figure 4.

Figure 6 shows a graph of the characteristic of the input and output of the embodiment shown in Figure 4.

Figure 7 shows a circuit of the third embodiment.

"T1" shows a MOSFET, "R1" shows a resister, "C1" and "C2" show parasitic capacitances, "Vout" shows an output voltage, "T2" shows nMOS, "T3" and "T4" show pMOS, "Vcc" shows a power source, "Vin" shows input voltage, "V'out" shows the change of the output voltage, "-Vcc" shows a minus power source, "Iin" shows input current, and "Iout" shows output current.

### -PREFERRED EMBODIMENT OF THE INVENTION-

Hereinafter, the first embodiment of the voltage follower circuit relates to the present invention is described with reference to the attached drawings.

In Figure 2, the voltage follower circuit uses cMOS comprised of nMOS ("T2", hereafter) and pMOS ("T3", hereafter), connects the drain of T2 to power source Vcc, grounds the source of T3, and connects the source of T2 and the drain of T3. Input voltage Vin is connected to the gates of T2 and T3, and an output terminal is connected to the drain of T3.

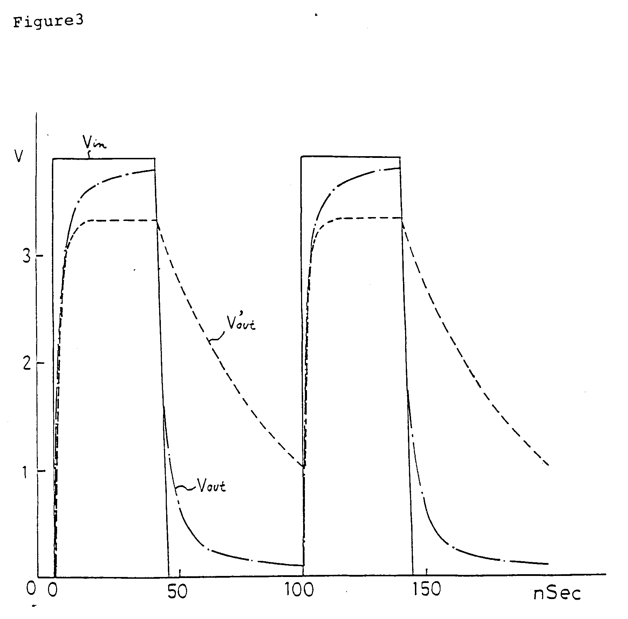

As shown in Figure 3, when input voltage Vin is 0V, output voltage is also 0V, and as input voltage Vin rises, output voltage Vout also rises. Here, the level of output voltage is preserved by the resistance of pMOS and Vin is almost the same with Vout. As Vin decreases, Vout also decreases. The parasitic capacitance C2 discharges in high speed because of carrying of current of pMOS. Expressing the change of output voltage of the circuit in Figure 1 by "V'out", the descent of the speed of V'out is very much slower than Vout. That is, in this embodiment, the output voltage is satisfactorily responsive.

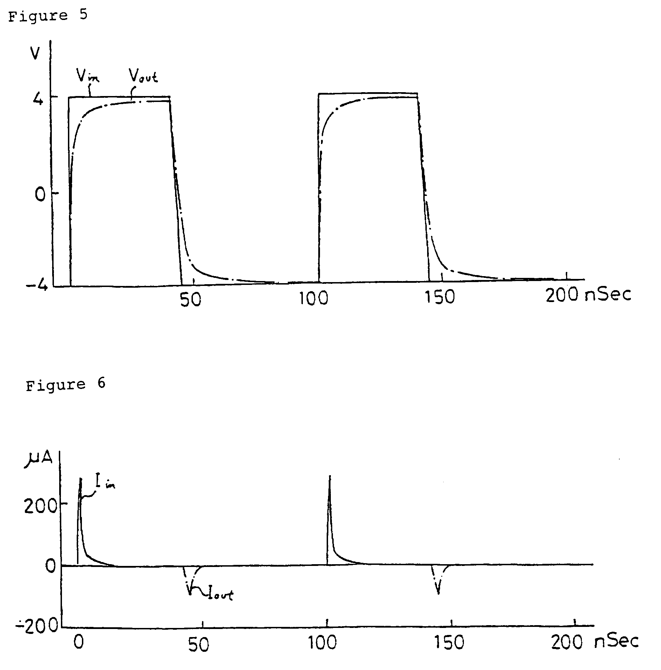

Figure 4 shows the second embodiment of the present invention. In this embodiment, the source of pMOS of the circuit in Figure 2 is not grounded but connected to a minus power source -Vcc. High responsive performance can be realized by such a construction, too, in the same way as in Figure 3. Figure 5 shows the relationship between Vin and Vout. Figure 6 shows the change of input current Iin and output current Iout according to Vin and Vout in Figure 5. It is clear from Figure 5 that the responsive performance makes good result. The electric current is generated only on the start point of the change of input and output: consequently, low electric power is consumed. The circuit in Figure 2 also consumes low power.

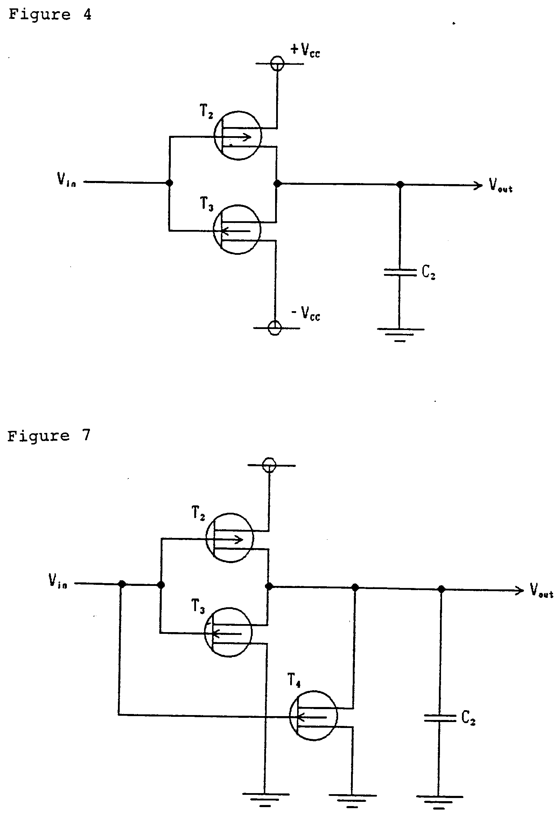

Figure 7 shows the third embodiment of the present invention. In this embodiment, pMOS ("T4", hereafter) parallel to T3 is added to the circuit in Figure 2. The electric discharge of parasitic capacitance C2 is much higher.

As mentioned above, the voltage follower circuit according to the present invention uses CMOS, connects power source to the drain of nMOS, connects the source of pMOS to the low voltage, connects the source of nMOS and the drain of pMOS, inputs the input voltage to the gates of nMOS and pMOS, and connects the drain of pMOS to the output terminal. Therefore, the output voltage can be preserved by the resistance between source drains of pMOS on non-conductive condition, and parasitic capacitance is discharged by conduction of pMOS. Consequently, it is possible to realize a responsive circuit preserving the necessary level of output voltage.

## Claims

1. A voltage follower circuit comprising nMOS whose drain is connected to power source and pMOS whose drain is connected to said source of nMOS and whose source is grounded, wherein input voltage is connected to gates of nMOS and pMOS, a source of nMOS is connected to an output terminal, and said output terminal is grounded through capacitance.

2. A voltage follower circuit comprising nMOS whose drain is connected to plus power source and pMOS whose drain is connected to said source of nMOS and whose source is connected to minus power source wherein input voltage is connected to gates of nMOS and pMOS, a source of nMOS is connected to an output terminal, and said output terminal is grounded through capacitance.

3. A voltage follower circuit comprising nMOS whose drain is connected to power source and the first pMOS whose drain is connected to said source of nMOS and whose source is grounded, wherein input voltage is connected to gates of nMOS and pMOS, a source of nMOS is connected to an output terminal, said output terminal is grounded through capacitance, the second pMOS is connected parallel with said capacitance, and said input voltage is connected to a gate of said second pMOS.
